# EUROPÄISCHE PATENTANMELDUNG

(11) **EP 3 726 942 A1**
(43) Veröffentlichungstag der Anmeldung: **21.10.2020**
(21) Anmeldenummer: 20166137.8
(22) Anmeldetag: 27.03.2020
(51) Int. Cl.: H05K 1/09, H05K 3/12, H05K 3/28, H05K 1/02

(54) **LED-MODUL MIT SILIKON-LEITERBAHN**

(30) Priorität: 10.04.2019 DE 102019109509
(71) Anmelder: Siteco GmbH, 83301 Traunreut (DE)
(72) Erfinder: Schroll, Katrin, 83301 Matzing (DE); Niederauer, Martin, 83301 Traunreut (DE); Wimmer, Kilian, 83362 Surberg (DE)
(74) Vertreter: Schmidt, Steffen

(57) **Zusammenfassung**

Die Erfindung betrifft ein LED-Modul aufweisend wenigstens eine LED, welche an einem Trägersubstrat befestigt ist, wobei eine Stromversorgung der LED wenigstens teilweise durch Leiterbahnen aus elektrisch leitfähigen Silikon gebildet ist, welche auf das Trägersubstrat aufgedruckt sind.

## Beschreibung

Die vorliegende Erfindung betrifft ein LED-Modul, welches zum Integrieren in einer Leuchte für Beleuchtungszwecke, insbesondere einer Innen- oder Außenleuchte, eingerichtet ist oder selbst bereits eine solche Leuchte darstellt.

Abhängig von dem elektronischen Gesamtsystem einer Leuchte können in einer Leuchte LED-Module vorgesehen sein, in welchen die LEDs (light-emitting diodes) als Lichtquellen der Leuchte enthalten sind. Die LED-Module können neben den LEDs auch noch weitere elektrische Komponenten enthalten und sind dafür eingerichtet, in der Leuchte an einen elektrischen Versorgungsanschluss angeschlossen zu werden. Die LED-Module im Stand der Technik sind auf den Leuchtentyp abgestimmt. Daher ist eine große Anzahl von verschiedenen LED-Modulen notwendig. Um die Lagerhaltung und Logistik für derartige LED-Module zu vereinfachen, ist es im Stand der Technik bereits bekannt, LED-Module individuell für einen bestimmten Leuchtentyp aus einer Art Baukastensystem zu fertigen. Eine Lösung sieht z.B. vor, dass eine Leiterplatte mit einem vorgefertigten Layout von Leitungspads mit LEDs bestückt wird und die Leitungspads mit Leiterbrücken zu Leitungsbahnen vervollständigt werden. Auf diese Weise lassen sich aus immer gleichen Komponenten verschiedene Layouts für LED-Anordnungen herstellen. Die Variationsmöglichkeiten sind jedoch begrenzt aufgrund der vorgegebenen Anordnung von Leiterpads auf der Leiterplatte.

Aufgabe der vorliegenden Erfindung ist es, ein LED-Modul sowie ein Herstellungsverfahren für ein LED-Modul bereitzustellen, welches auf einfache Weise das individuelle Anfertigen von Layouts von LED-Konfigurationen ermöglicht.

Gelöst wird die Aufgabe durch ein LED-Modul nach Anspruch 1 sowie durch ein Herstellungsverfahren nach Anspruch 11.

Eine Besonderheit des LED-Moduls der vorliegenden Erfindung besteht darin, dass die LEDs (worunter jede Form von Halbleiterlichtquellen einschließlich organischer lichtemittierender Dioden verstanden werden) durch leitfähiges Silikon kontaktiert werden, das mittels eines Druckverfahrens auf ein Trägersubstrat aufgebracht wird. Im 3D-Druck lassen sich die Leiterbahnen aus leitfähigem Silikon individuell aufdrucken. Die LEDs lassen sich daher frei auf dem Trägersubstrat anordnen, um individuell eine Modulvariante für den vorgegebenen Anwendungszweck zu bilden. Die Modulvarianten können sich durch die Verschaltung der LEDs untereinander unterscheiden. Durch die Verwendung von leitfähigem Silikon können die Leiterbahnen ähnlich wie Silikonlinsen auf das Substrat aufgedruckt werden. Es ist kein zusätzliches Produktionsgerät notwendig. Das Layout kann individuell angepasst werden, ohne dass eine größere Lagerhaltung von Komponenten erforderlich ist. Es kann auch kurzfristig auf Kundenwünsche reagiert werden. Da mehrere Varianten eines Moduls auf einen Ausgangstyp beruhen, ergeben sich Kosteneinsparungen ohne die Anzahl der Varianten einschränken zu müssen.

Gemäß einer bevorzugten Ausführungsform verbinden die gedruckten Leiterbahnen aus leitfähigem Silikon mehrere LEDs in Reihen- und/oder Parallelschaltung elektrisch. Es können unterschiedlich farbige LEDs miteinander verbunden werden, z.B. in den Farben rot, grün, blau, um weißes Licht zu erzeugen. Die Anzahl der Dioden kann abhängig von der gewünschten Leistungsstärke gewählt werden. Die Zahl der in Reihe bzw. parallel miteinander verbundenen LEDs kann abhängig von der zur Verfügung stehenden Versorgungsspannung eines LED-Treibers bzw. eines elektronischen Vorschaltgerätes für die LEDs gewählt werden.

Gemäß einer bevorzugten Ausführungsform ist wenigstens eine weitere elektrische Komponente des LED-Moduls, insbesondere ein Sensor und/oder ein Vorschaltgerät, mittels einer gedruckten elektrischen Leiterbahn elektrisch angebunden. Beispielsweise kann ein Sensor in einer Aussparung oder Öffnung einer Abdeckung des LED-Moduls, vorzugsweise mit Silikon abgedichtet, integriert sein. Zum Anschluss des Sensors lässt sich die Leiterbahn direkt auf die Abdeckung aufdrucken. Da das leitfähige Silikon transparent oder wenigstens transluzent ist, kann die Leiterbahn auch über einen transparenten Bereich der Abdeckung geführt werden, ohne die Lichtabgabe durch diesen Bereich zu stören. Ferner kann auf dem gleichen Trägersubstrat, auf welchem die LEDs angeordnet sind, auch ein elektronisches Vorschaltgerät vorgesehen sein. Die LEDs können direkt mit dem elektronischen Vorschaltgerät durch die gedruckten Leiterbahnen verbunden werden.

Gemäß einer bevorzugten Ausführungsform ist auf dem Trägersubstrat im Bereich der wenigstens einen LED eine Optik, insbesondere eine Linse und/oder ein Reflektor, zur Lichtlenkung des von der LED abgegebenen Lichts aus nicht leitfähigem Silikon aufgedruckt. Gedruckte Linsen aus Silikon sind beispielsweise aus der deutschen Patentanmeldung DE 10 2018 109 408 der gleichen Anmelderin bekannt. Da sowohl die Silikonlinse als auch die Leiterbahn aus Silikon mit der gleichen Vorrichtung aufgebracht werden können, ergeben sich durch die Kombination der beiden Herstellungsverfahren für die Linsen und für die Leiterbahnen erhebliche Einsparungen. Ferner können die Optiken aus nicht leitfähigem Silikon auch dazu dienen, die Leiterbahnen aus leitfähigem Silikon zu isolieren, um die spannungsführenden Teile gegen eine Berührung oder gegen Feuchtigkeit zu schützen. Ferner können auch die LEDs vollständig durch die Optiken aus nicht leitenden Silikon abgedeckt sein, um für die notwendige elektrische Isolierung bzw. für einen Berührungsschutz zu sorgen.

Gemäß einer bevorzugten Ausführungsform ist eine Dichtung, ein Berührungsschutz und/oder eine Kabeldurchführung aus nicht leitfähigem Silikon auf das Trägersubstrat aufgedruckt. Wie vorhergehend für die Optiken ausgeführt, ist die Herstellung der weiteren Komponenten aus Silikon in Verbindung mit den Leiterbahnen aus leitfähigem Silikon bevorzugt, weil die Bedruckung des Trägersubstrats in einem Herstellungsverfahren leicht kombiniert werden kann.

Gemäß einer bevorzugten Ausführungsform ist ein elektrischer Anschluss, z.B. ein Steckeranschluss, des LED-Moduls zum elektrischen Verbinden des LED-Moduls mit einem benachbarten Modul aus gedrucktem leitfähigem Silikon gebildet. Die elektrische Verbindung zwischen zwei LED-Modulen ist besonders kritisch, weil die LED-Module sich unter Wärmeeinfluss im Betrieb ausdehnen. Die Verwendung von Verbindungen, insbesondere Steckanschlüssen, aus leitfähigem Silikon hat dabei den Vorteil, dass die Verbindung aufgrund ihrer Elastizität thermische Spannungen zwischen den Modulen ausgleichen kann.

Gemäß einer bevorzugten Ausführungsform weist das LED-Modul, insbesondere ein LED-Modul, das selbst eine Leuchte darstellt, eine Dichtung aus Silikon auf und es ist wenigstens ein Teil des leitfähigen Silikons der Leiterbahnen in der Silikondichtung integriert. Für Leuchten in feuchtigkeitssensiblen Bereichen oder für gasdichte Leuchten sind Dichtungen aus einem Elastomer notwendig. Die Dichtungen aus Silikon können im gleichen Verfahren wie die elektrisch leitfähigen Leiterbahnen aus Silikon gedruckt werden. Ferner können die elektrisch leitfähigen Bahnen in den Silikondichtungen integriert werden, indem zunächst die elektrische Leiterbahn aus leitfähigem Silikon gedruckt wird und anschließend aus nicht leitfähigem Silikon eine Dichtung darüber gedruckt wird.

Gemäß einer bevorzugten Ausführungsform weist das LED-Modul eine Antenne auf, welche mit einer gedruckten Leiterbahn aus elektrisch leitfähigem Silikon kontaktiert ist. In vielen Anwendungen ist eine Funkschnittstelle in dem LED-Modul bzw. der Leuchte gewünscht, um das Leuchtensystem von außen schalten oder programmieren zu können, ohne direkt darauf zuzugreifen. Die Antenne kann in der Dichtung aus elektrisch isolierendem Silikon integriert werden, weil diese Dichtung in der Regel nicht durch metallische Gehäuseteile abgeschirmt ist. Die Kontaktierung der Antenne muss im Stand der Technik mit eigenen Drähten durch die Dichtung erfolgen. Dies ist mit dem erfindungsgemäßen Ausbilden der Leiterbahn aus gedrucktem elektrisch leitfähigem Silikon nicht nötig, weil die Leiterbahnen selbst in der Dichtung integriert sind.

Gemäß einer bevorzugten Ausführungsform ist die Antenne selbst aus elektrisch leitfähigem Silikon gebildet. Dies vereinfacht weiter die Ausbildung der Antenne in einem LED-Leitermodul.

Gemäß einer bevorzugten Ausführungsform ist die Antenne in der Silikondichtung des LED-Moduls integriert. Das Einfügen der Antenne in die Dichtung ist von Vorteil, weil die Dichtung eine Längserstreckung aufweist, die sich zum Anordnen von einer länglichen Antenne eignet. Das Integrieren einer Antenne aus leitfähigem Silikon in der Dichtung, welche im Übrigen aus nicht leitfähigem Silikon gebildet ist, vereinfacht weiter die Herstellung. Anstelle der Antenne oder zusätzlich zu der Antenne können noch andere integrierte Schaltungen in einer Abdeckung oder einer Dichtung des LED-Moduls integriert sein. Beispielsweise kann ein Helligkeitssensor oder ein Anwesenheitsdetektor in einer Vertiefung oder einer Öffnung eines LED-Moduls mit Silikon angebracht werden, wobei das Silikon im gleichen Verarbeitungsschritt wie das Drucken der Leiterbahnen aufgebracht werden kann.

In einem Herstellungsverfahren gemäß der vorliegenden Erfindung kann beispielsweise vorgesehen sein, dass beim Drucken der Leiterbahnen aus elektrisch leitfähigem Silikon im gleichen 3D-Druckverfahren auch noch optische Komponenten aus nicht leitfähigem Silikon oder weiter Zusatzkomponenten wie z.B. eine Dichtung, auf das Trägersubstrat aufgedruckt werden.

Weitere Vorteile und Merkmale der vorliegenden Erfindung werden aus der nachfolgenden Beschreibung bevorzugter Ausführungsformen deutlich, die in Verbindung mit den beigefügten Figuren gegeben wird. In den Figuren ist Folgendes dargestellt:
- Figur 1: zeigt eine Aufsicht auf ein LED-Modul gemäß einer Ausführungsform der vorliegenden Erfindung.
- Figur 2: zeigt einen Querschnitt durch ein LED-Modul nach Figur 1 in einem Teilbereich.
- Figur 3: zeigt einen schematischen Querschnitt durch eine Leuchte gemäß einer weiteren Ausführungsform mit einem in einer Abdeckung integrierten Sensor.
- Figur 4: zeigt eine Aufsicht auf eine Leuchte gemäß einer weiteren Ausführungsform.
- Figur 5: zeigt eine Aufsicht auf eine Leuchte gemäß einer weiteren Ausführungsform.

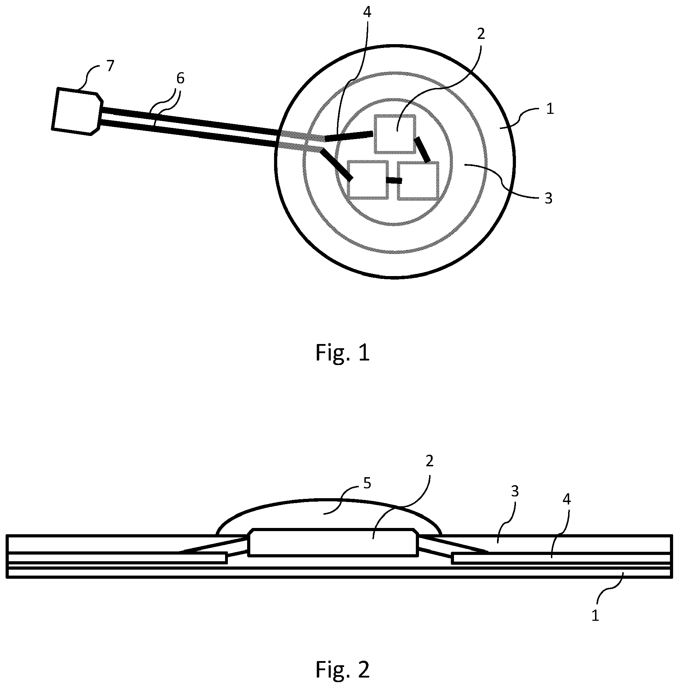

Bezug nehmend auf die Figuren 1 und 2 wird eine erste Ausführungsform eines LED-Moduls beschrieben. Das LED-Modul umfasst auf einem Trägersubstrat 1 drei LEDs 2, die beispielsweise in den Farben Rot, Grün und Blau ausgebildet sein können. Die LEDs 2 sind auf dem Trägersubstrat mit einem Befestigungsmaterial, welches im vorliegenden Fall nicht leitfähiges Silikon 3 ist, mechanisch befestigt. In dem Silikonmaterial sind aus leitfähigem Silikon gebildete Leiterbahnen 4 vorgesehen, welche die elektrischen Anschlüsse der LEDs 2 kontaktieren. Die elektrischen Leiterbahnen 4 werden mittels eines 3D-Druckverfahrens aufgebracht. Sie können zusammen mit dem nicht leitfähigen Silikon 3 ausgebildet werden. Über den LEDs 2 ist ferner noch eine Linse 5 aus nicht leitfähigem Silikon vorgesehen. Auch die Linse 5 kann in dem gleichen Druckverfahren wie die Leiterbahnen 4 aus Silikon hergestellt werden.

Wie im Querschnitt nach Figur 2 zu sehen ist, ist die LED 2 vollständig durch Silikon gekapselt. Ferner sind auch die elektrischen Leiterbahnen 4 durch das nicht leitfähige Silikon 3 bzw. die Linse 5 isoliert. Dadurch lässt sich in einem 3D-Druckverfahren einfach ein vollständig gekapseltes LED-Modul bilden, welches z.B. einen Staubschutz oder Berührungsschutzbereitstellt. Ein weiterer Vorteil des 3D-Druckverfahrens besteht darin, dass die Anordnung der Leiterbahnen einfach variiert werden kann. Beispielsweise können mehr oder weniger LEDs in dem Modul vorgesehen werden, um das Modul für lichtstärkere und lichtschwächere Anwendungen anzupassen.

Die elektrischen Leiterbahnen 4 sind in dem LED-Modul mit metallischen Leiterbahnen 6 verbunden, die zu einem elektrischen Anschluss 7 führen. Der elektrische Anschluss 7 kann beispielsweise durch Silikon gebildet sein, wobei die Leitungen 6 mit leitfähigem Silikon verbunden sind und außen eine Isolierung aus nicht leitfähigem Silikon gebildet ist. Der Anschluss 7 kann ebenfalls in einem 3D-Druckverfahren hergestellt werden.

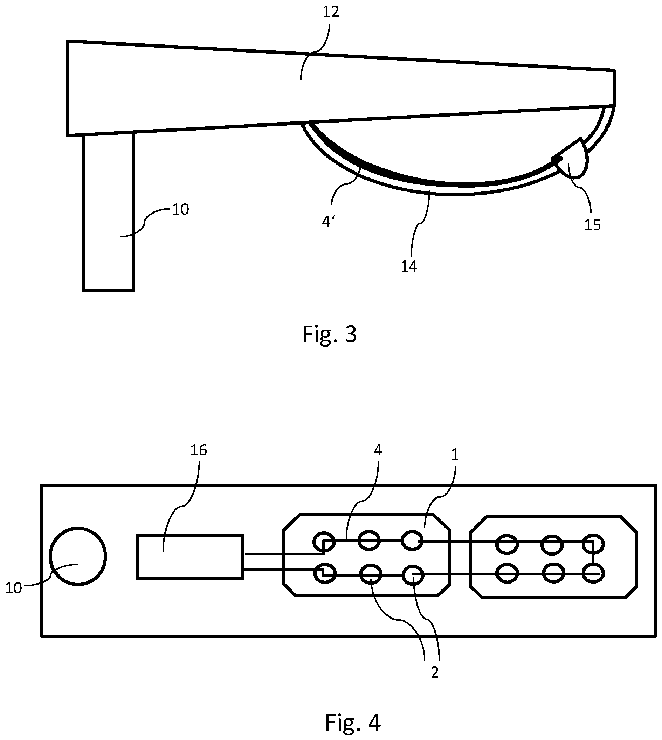

Figur 3 zeigt eine alternative Ausführungsform, bei welcher ein LED-Modul als Leuchtenkopf 12 auf einem Leuchtenmast 10 ausgebildet ist. Die LEDs 2 sind in dem Leuchtenkopf 12 integriert und in der Figur 3 nicht zu sehen. Eine Besonderheit der Leuchte besteht in der Abdeckung 14, welche die Lichtaustrittsfläche der Leuchte abdeckt. In der Abdeckung 14 ist eine Öffnung vorgesehen, in welcher ein Sensor 15, z.B. ein Anwesenheitssensor oder ein Lichtsensor, integriert ist. Der Sensor 15 ist mit Silikon in der Öffnung der Abdeckung 14 eingepasst und abgedichtet. Ferner ist der Sensor 15 elektrisch mit einer Leiterbahn 4' kontaktiert, die aus leitfähigem Silikon gebildet ist. Die Leiterbahn 4' ist direkt auf den transparenten Bereich der Abdeckung 14 aufgedruckt. In dem Erscheinungsbild der Leuchte stört die Leiterbahn 4' nicht, weil das elektrisch leitfähige Silikon fast die gleiche Transparenz aufweist, wie die Abdeckung 14 selbst. Vorzugsweise sind die Leiterbahnen 4' zusammen mit dem Silikon des Sensors 15 in einem Verfahrensprozess durch 3D-Druck aufgebracht.

Die Figur 4 zeigt eine Aufsicht auf eine Lichtaustrittsfläche eines LED-Moduls, z.B. eines Leuchtenkopfes 12, wie in der Ausführungsform nach Figur 3 dargestellt. In dieser Ausführungsform sind mehrere LEDs 2 auf zwei Trägersubstraten 1 verteilt angeordnet. Alle LEDs 2 sind in Reihe mit einer aus leitfähigem Silikon gedruckten Leiterbahn 4 verbunden und an ein elektrisches Vorschaltgerät 16 angeschlossen. Auch die Verbindung zwischen den Trägersubstraten und zum elektrischen Vorschaltgerät 16 sind mit Leiterbahnen aus gedrucktem leitfähigen Silikon gebildet. Diese Ausführungsform hat den Vorteil, dass auch bei thermischen Spannungen zwischen den Bestandteilen der Leuchte die Leiterbahnen nicht beschädigt werden, weil die Leiterbahnen 4 aufgrund des Materials Silikon eine ausreichende Elastizität besitzen.

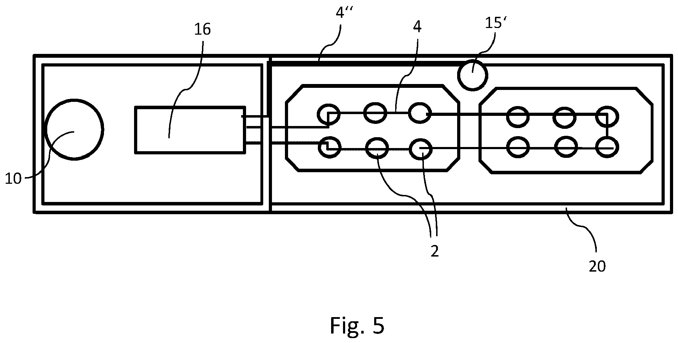

Die Figur 5 zeigt eine Variante der Ausführungsform nach Figur 4, in der zusätzlich eine umlaufende Dichtung 20 vorgesehen ist. Die Dichtung dient z.B. dazu, um die Abdeckung 14, wie in Figur 3 dargestellt, gegenüber einer Trägerfläche des Moduls abzudichten. Ferner ist eine Zusatzeinheit, z.B. ein Sensor 15' oder eine Kamera integriert. Eine Besonderheit besteht in dem elektrischen Anschluss der zusätzlichen elektrischen Einheit 15'. Diese erfolgt durch eine gedruckte Leiterbahn 4", die aus elektrisch leitfähigem Silikon gebildet ist, wobei die Leiterbahn 4" in der Dichtung 20 aus nicht leitfähigem Silikon integriert ist. Die Leiterbahn 4" lässt sich zusammen mit der Dichtung 20 in einem 3D-Druckverfahren herstellen.

Weitere Ausführungsformen sind im Rahmen der Erfindung, welche durch die Ansprüche definiert ist, möglich. Beispielsweise können weitere elektrische Bauteile in dem LED-Modul mittels gedruckter Silikonleiterbahn kontaktiert werden. In der Figur 5 wurde z.B. ein zusätzliches Bauteil 15' in Form eines Sensors oder einer Kamera beschrieben. An der gleichen Stelle kann beispielsweise auch eine ganze Antenne in der Dichtung 20 des Leuchtenmoduls integriert werden. Die Antenne selbst kann aus leitfähigem Silikon gebildet sein.

Weitere Ausführungsformen sind möglich, bei welchen die elektrischen Leiterbahnen aus herkömmlichen metallischen Leiterbahnen und gedruckten Silikonleiterbahnen kombiniert sind. Beispielsweise können einige der Verdrahtungen zur Kontaktierung der LEDs in Form einer Leiterplatte vorgesehen sein und zur Ausbildung der gewünschten Schaltung weitere gedruckte Silikonleiterbahnen vorgesehen sein. Dadurch kann ein festes Layout einer Leiterplatte mit fest vorgegebenen metallischen Leiterbahnen in verschiedenen Weisen verwendet werden, indem die verbleibenden Leiterbahnen individuell durch gedruckte Silikonleiterbahnen zu der gewünschten Schaltung komplementiert werden.

### BEZUGSZEICHENLISTE

- 1: Trägersubstrat
- 2: LEDs
- 3: leitfähiges Silikon
- 4, 4', 4": Leiterbahn
- 5: Linse
- 6: metallischer Leiter
- 7: elektrischer Anschluss
- 10: Leuchtenmast
- 12: Leuchtenkopf
- 14: Abdeckung
- 15, 15': Sensor
- 16: elektrisches Vorschaltgerät
- 20: Dichtung

## Patentansprüche

1. LED-Modul aufweisend:
wenigstens eine LED (2), welche an einem Trägersubstrat (1) befestigt ist,
**dadurch gekennzeichnet, dass** eine Stromversorgung der LED (2) wenigstens teilweise durch Leiterbahnen (4) aus elektrisch leitfähigen Silikon gebildet ist, welche auf das Trägersubstrat (1) aufgedruckt sind.

2. LED-Modul nach Anspruch 1, wobei die gedruckten Leiterbahnen (4) aus leitfähigem Silikon mehrere LEDs (2) in Reihen- und/oder Parallelschaltung elektrisch verbinden.

3. LED-Modul nach einem der vorhergehenden Ansprüche, wobei wenigstens eine weitere elektrische Komponente des LED-Moduls, insbesondere ein Sensor (15, 15') und/oder ein Vorschaltgerät (16), mittels einer gedruckten elektrischen Leiterbahn (4', 4") elektrisch angebunden ist.

4. LED-Modul nach einem der vorhergehenden Ansprüche, wobei auf dem Trägersubstrat (1) im Bereich der wenigstens einen LED (2) eine Optik, insbesondere eine Linse (5) und/oder ein Reflektor, zur Lichtlenkung des von der LED (2) abgegebenen Lichts aus nicht leitfähigem Silikon aufgedruckt ist.

5. LED-Modul nach einem der vorhergehenden Ansprüche, wobei eine Dichtung (20), ein Berührungsschutz und/oder eine Kabeldurchführung aus nicht leitfähigem Silikon auf das Trägersubstrat (1) aufgedruckt ist.

6. LED-Modul nach einem der vorhergehenden Ansprüche, wobei ein elektrischer Anschluss (7), z.B. ein Steckeranschluss, des LED-Moduls zum elektrischen Verbinden des LED-Moduls mit einem benachbarten Modul aus gedrucktem leitfähigem Silikon gebildet ist.

7. LED-Modul nach einem der vorhergehenden Ansprüche, wobei das LED-Modul eine Dichtung (20) aus Silikon aufweist und wenigstens ein Teil des leitfähigen Silikons der Leiterbahnen (4, 4', 4") in der Silikondichtung integriert ist.

8. LED-Modul nach einem der vorhergehenden Ansprüche, wobei das LED-Modul eine Antenne aufweist, welche mit einer gedruckten Leiterbahn aus elektrisch leitfähigem Silikon kontaktiert ist.

9. LED-Modul nach Anspruch 8, wobei die Antenne selbst aus elektrisch leitfähigem Silikon gebildet ist.

10. LED-Modul nach Anspruch 8 oder 9 mit Rückbezug auf Anspruch 7, wobei die Antenne in der Silikondichtung (20) des LED-Moduls integriert ist.

11. Verfahren zum Herstellen eines LED-Moduls, wobei das Verfahren folgende Schritte umfasst:
Bereitstellen eines Trägersubstrats (1);
Aufbringen von wenigstens einer LED (2) auf das Trägersubstrat (1);
Drucken einer Leiterbahn (4) zum elektrischen Kontaktieren der wenigstens einen LED (2) mittels 3D-Druck aus elektrisch leitfähigem Silikon.

12. Herstellungsverfahren nach Anspruch 11, das ferner folgenden Schritt umfasst:
Aufdrucken einer optischen Komponente, insbesondere einer Linse (5) und/oder eines Reflektors, aus nicht leitfähigem Silikon mittel 3D-Druck auf das Trägersubstrat im Bereich der LED, und/ oder Aufdrucken von Zusatzkomponenten des LED-Moduls aus Silikon, insbesondere eine Dichtung (20).
